(19)

Europäisches Patentamt

European Patent Office

Office européen des brevets

(11) **EP 3 587 918 A1**

(12) **EUROPEAN PATENT APPLICATION**
published in accordance with Art. 153(4) EPC

(43) Date of publication:
**01.01.2020 Bulletin 2020/01**

(21) Application number: **18756810.0**

(22) Date of filing: **26.02.2018**

(51) Int Cl.:
*F21V 9/00* (2018.01)  *C09K 11/59* (2006.01)
*C09K 11/64* (2006.01)  *C09K 11/80* (2006.01)
*F21V 7/24* (2018.01)  *F21V 7/26* (2018.01)
*F21V 7/28* (2018.01)  *F21V 7/30* (2018.01)
*H01L 33/50* (2010.01)  *F21Y 115/00* (2016.01)

(86) International application number:
**PCT/JP2018/006845**

(87) International publication number:
**WO 2018/155665 (30.08.2018 Gazette 2018/35)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD TN**

(30) Priority: **27.02.2017 JP 2017034529**

(71) Applicant: **Citizen Electronics Co., Ltd. Fujiyoshida-shi, Yamanashi 403-0001 (JP)**

(72) Inventor: **ARAI, Makoto Fujiyoshida-shi Yamanashi 403-0001 (JP)**

(74) Representative: **Hoffmann Eitle Patent- und Rechtsanwälte PartmbB Arabellastraße 30 81925 München (DE)**

(54) **SEMICONDUCTOR LIGHT-EMITTING DEVICE AND ILLUMINATION DEVICE**

(57)    The present invention addresses the problem of providing a light-emitting device capable of achieving color appearance that is natural, bright, clearly visible, and pleasant in a subject illuminated by the light, and is furthermore capable of achieving light that can improve the appearance of skin. The problem addressed by the present invention is solved by a light-emitting device that has a semiconductor light-emitting element, wherein the light-emitting device emits light which exhibits improved saturation on average, and in which the values of $\Delta C_{14}$ and $\Delta C_{11}$ of fifteen corrected Munsell chroma satisfy specific values and specific relationships.

EP 3 587 918 A1

**Description**

Technical Field

The present invention relates to a semiconductor light-emitting device, and more particularly, to a light-emitting device and an illumination device capable of emitting light that improves the appearance of skin.

Background Art

In a semiconductor light-emitting device including a semiconductor light-emitting element, power consumption is significantly suppressed as compared with a fluorescent lamp or an incandescent lamp, and therefore, such a semiconductor light-emitting device is distributed in the market as an energy saving device by being mounted on general lighting. For achieving energy saving, emphasis is on the light emission efficiency of a light-emitting device mounted on general lighting. For that reason, a semiconductor light-emitting device capable of emitting pseudo white light typically by combining a YAG yellow phosphor with a GaN blue semiconductor light-emitting element has been adopted.

On the other hand, light-emitting devices intended to improve not only the light emission efficiency, but also the quality of light to be emitted, have been developed. For example, a semiconductor light-emitting device capable of achieving high color rendering property using an indicator called "color rendering property *Ra*" defined by the CIE, or a numerical indicator of a color shift from a light of a perfect radiator as a reference light has been developed. On the other hand, from a viewpoint different from the color rendering property *Ra*, a semiconductor light-emitting device that can realize a natural, vivid, highly visible and comfortable color appearance of subjects actually irradiated with light has been developed (for example, see Patent Documents 1, 2 and 3).

On the other hand, illumination to improve the appearance of certain objects has been developed.

For example, Patent Document 4 discloses an illumination device that improves the appearance of skin by specifying the intensity of light at each of wavelengths 500 nm, 550 nm, 600 nm and 640 nm with reference to a peak of light emitted from a blue semiconductor light-emitting element. It is noted that, in the illumination disclosed in Patent Document 4, the appearance of skin is based on the evaluation method disclosed in Patent Document 5.

Patent Document 6 discloses a light source device that can make red look high color saturation by focusing on a test color *R9* for evaluating special color rendering.

CITATION LIST

Patent documents

> Patent document 1: WO 2013/031942
> Patent document 2: WO 2013/031943
> Patent document 3: WO 2015/099115
> Patent document 4: Japanese Unexamined Patent Application Publication No. 2013-058473
> Patent document 5: Japanese Unexamined Patent Application Publication No.H11-258047
> Patent document 6: Japanese Unexamined Patent Application Publication No. 2016-173949

Summary of Invention

Technical Problem

As disclosed in Patent Document 4, an illumination device capable of improving the appearance of skin has been examined.

However, for a light-emitting device as disclosed in Patent Documents 1 to 3 that can realize natural, vivid, highly visible and comfortable color appearance on a subject actually irradiated with light, an illumination device capable of improving the appearance of skin has not been examined.

Under such circumstances, an object of the present invention is to provide a light-emitting device capable of realizing a light that can realize a natural, vivid, highly visible and comfortable color appearance, and further, can improve the appearance of skin in a subject actually irradiated with light.

Solution to Problem

In the light-emitting devices disclosed in Patent Documents 1 to 3, the average ($\Delta C_{ave}$) of the saturation difference $\Delta C_n$ between a light emitted from a light-emitting device and a reference light in the CIE $L^*a^*b^*$ space takes a positive value, and the device is characterized in that the color saturation is improved on average as compared with the reference light. The present inventors focused attention on the relationship between the value of each $\Delta C$ and the appearance of skin in the 15 Munsell renotation color samples, in a light-emitting device in which the color saturation is improved on average as above, and found that the value of $\Delta C$ in a specific color samples, specifically the values of $\Delta C_{14}$ and $\Delta C_{11}$, is closely related to the appearance of skin, and completed the present invention.

The present invention includes the following.

[1] A light-emitting device including at least a semiconductor light-emitting element as a light-emitting element and capable of emitting light satisfying the requirements defined in the following Conditions I to V in the main radiant direction.

Condition I:

The distance $D_{uv}$ from the black body radiation locus satisfies

$$-0.0200 \leq D_{uv} < 0.$$

Condition II:

Letting an $a^*$ value and a $b^*$ value in the following CIE 1976 $L^*a^*b^*$ color space of 15 Munsell renotation color samples of from #01 to #15 listed below when mathematically assuming illumination by light emitted from the light-emitting device in the radiant direction be $a^*_{nSSL}$ and $b^*_{nSSL}$ (where n is a natural number from 1 to 15), respectively,

and an $a^*$ value and a $b^*$ value in the CIE 1976 $L^*a^*b^*$ color space of 15 Munsell renotation color samples when mathematically assuming illumination with reference light selected according to the correlated color temperature $T_{SSL}(K)$ of light emitted in the radiant direction be $a^*_{nref}$ and $b^*_{nref}$ (where n is a natural number from 1 to 15), respectively, the saturation difference $\Delta C_n$ satisfies

$$-3.0 \leq \Delta C_n \leq 10.0 \text{ (n is a natural number from 1 to 15).}$$

(n is a natural number from 1 to 15).

Condition III:

$\Delta C_{ave}$ representing the average of the $\Delta C_n$ (n is an integer from 1 to 15) satisfies

$$0.5 \leq \Delta C_{ave} \leq 6.0.$$

Condition IV: The saturation ($\Delta C_{14}$) of #14 in the Munsell renotation color samples satisfies $0 \leq \Delta C_{14} \leq 8.0$.

Condition V: The ratio ($\Delta C_{14}/\Delta C_{11}$) of the saturation ($\Delta C_{14}$) of #14 in the Munsell renotation color samples to the saturation ($\Delta C_{11}$) of #11 in the Munsell renotation color samples satisfies

$$0.1 \leq \Delta C_{14}/\Delta C_{11} \leq 8.0,$$

where

$$\Delta C_n = \sqrt{\{(a^*_{nSSL})^2 + (b^*_{nSSL})^2\}} - \sqrt{\{(a^*_{nref})^2 + (b^*_{nref})^2\}},$$

with the 15 Munsell renotation color samples being:

| #01 | 7.5P | 4/10 |
|-----|------|------|
| #02 | 10PB | 4/10 |
| #03 | 5PB | 4/12 |
| #04 | 7.5B | 5/10 |
| #05 | 10BG | 6/8 |

(continued)

| #06 | 2.5BG | 6/10 |
|------|-------|------|
| #07 | 2.5G | 6/12 |
| #08 | 7.5GY | 7/10 |
| #09 | 2.5GY | 8/10 |
| #10 | 5Y | 8.5/12 |
| #11 | 10YR | 7/12 |
| #12 | 5YR | 7/12 |
| #13 | 10R | 6/12 |
| #14 | 5R | 4/14 |
| #15 | 7.5RP | 4/12 |

[2] The light-emitting device according to [1], wherein
$D_{uv}$ defined in the Condition I satisfies $-0.0150 \leq D_{uv} < 0$, the $\Delta C_n$ defined by the Condition II satisfies $-2.0 \leq \Delta C_n \leq 10.0$, and the $\Delta C_{ave}$ defined by the Condition III satisfies $0.5 \leq \Delta C_{ave} \leq 4.0$.
[3] The light-emitting device according to [1] or [2], wherein $\Delta C_{14}/\Delta C_{11}$ defined by the Condition V satisfies $0.1 \leq \Delta C_{14}/\Delta C_{11} \leq 3.0$.
[4] The light-emitting device according to [1] or [2], wherein $\Delta C_{14}/\Delta C_{11}$ defined by the Condition V satisfies $0.1 \leq \Delta C_{14}/\Delta C_{11} \leq 2.0$.
[5] The light-emitting device according to any one of [1] to [4], further satisfying Condition VI.

Condition VI:
The saturation ($\Delta C_{12}$) of #12 in the Munsell renotation color samples satisfies

$$0 \leq \Delta C_{12} \leq 8.0.$$

[6] The light-emitting device according to any one of [1] to [4], further satisfying Condition VII.

Condition VII:
The saturation ($\Delta C_{13}$) of #13 in the Munsell renotation color samples satisfies

$$0 \leq \Delta C_{13} \leq 8.0.$$

[7] The light-emitting device according to [5] or [6], satisfying both the Condition VI and the Condition VII.
[8] The light-emitting device according to any one of [1] to [7], further satisfying Condition VIII.

Condition VIII:

Letting the spectral distribution of light emitted from the light-emitting device in the radiant direction be $\varphi_{SSL}(\lambda)$, the spectral power distribution of reference light selected according to the correlated color temperature $T_{SSL}(K)$ of light emitted from the light-emitting device in the radiant direction be $\varphi_{ref}(\lambda)$, tristimulus values of light emitted from the light-emitting device in the radiant direction be ($X_{SSL}$, $Y_{SSL}$, $Z_{SSL}$), and tristimulus values of reference light selected according to the correlated color temperature $T_{SSL}(K)$ of light emitted from the light-emitting device in the radiant direction be ($X_{ref}$, $Y_{ref}$, $Z_{ref}$), and
defining normalized spectral power distribution $S_{SSL}(\lambda)$ of light emitted from the light-emitting device in the radiant direction, normalized spectral power distribution $S_{ref}(\lambda)$ of reference light selected according to the correlated color temperature $T_{SSL}(K)$ of light emitted from the light-emitting device in the radiant direction, and the difference $\Delta S(\lambda)$ of these normalized spectral power distributions as

$$S_{SSL}(\lambda) = \varphi_{SSL}(\lambda)/Y_{SSL},$$

$$S_{ref}(\lambda) = \varphi_{ref}(\lambda)/Y_{ref},$$

and

$$\Delta S(\lambda) = S_{ref}(\lambda) - S_{SSL}(\lambda),$$

respectively,

letting the wavelength giving the local maximum value of $S_{SSL}(\lambda)$ at the longest wavelength in the wavelength range of from 380 nm to 780 nm be $\lambda_R$ (nm), when a wavelength $\Lambda4$ giving the value of $S_{SSL}(\lambda_R)/2$ on the long wavelength side of $\lambda_R$ exists,

the indicator $A_{cg}$ represented by the following Formula (1-1) is -30 < $A_{cg} \leq$ 120,

while letting the wavelength giving the local maximum value of $S_{SSL}(\lambda)$ at the longest wavelength in the wavelength range of from 380 nm to 780 nm be $\lambda_R$ (nm), when a wavelength $\Lambda4$ giving the value of $S_{SSL}(\lambda_R)/2$ on the long wavelength side of $\lambda_R$ does not exist,

the indicator $A_{cg}$ represented by the following Formula (1-2) is -30 < $A_{cg} \leq$ 120.

[Math 1]

$$A_{cg} = \int_{380}^{495} \Delta S(\lambda)d\lambda + \int_{495}^{590} (-\Delta S(\lambda))d\lambda + \int_{590}^{\Lambda4} \Delta S(\lambda)d\lambda \qquad (1-1)$$

[Math 2]

$$A_{cg} = \int_{380}^{495} \Delta S(\lambda)d\lambda + \int_{495}^{590} (-\Delta S(\lambda))d\lambda + \int_{590}^{780} \Delta S(\lambda)d\lambda \qquad (1-2)$$

[9] The light-emitting device according to any one of [1] to [8], including at least one green phosphor and at least one red phosphor.

[10] The light-emitting device according to [9], wherein the green phosphor includes a LuAG phosphor.

[11] The light-emitting device according to [9] or [10], wherein the red phosphor includes a CASN phosphor.

[12] The light-emitting device according to any one of [1] to [8], including at least two types of green phosphors.

[13] The light-emitting device according to [12], wherein the at least two green phosphors are selected from an LuAG phosphor, a $\beta$-SiAlON phosphor, and a chlorosilicate phosphor, and include at least an LuAG phosphor.

[14] The light-emitting device according to any one of [1] to [8], including at least two types of red phosphors.

[15] The light-emitting device according to [14], wherein the red phosphor includes a CASN phosphor.

[16] An illumination device including the light-emitting device according to any one of [1] to [15].

Advantageous Effects of Invention

According to the present invention, a light-emitting device capable of realizing a light that can realize a natural, vivid, highly visible and comfortable color appearance, and further, can improve the appearance of skin can be provided.

Description of Embodiments

Hereinafter, the present invention will be described in more detail.

One embodiment of the present invention is a light-emitting device including at least a semiconductor light-emitting element as a light-emitting element.

The light-emitting device including the semiconductor light-emitting element may be a light-emitting device that emits white light when mounted on an illumination device, but is not limited thereto. Typical examples of such a light-emitting device include a light-emitting device including a violet or blue semiconductor light-emitting element as a light-emitting element, and including a green phosphor for converting light from the light-emitting element to green light, and a red phosphor for converting light from the light-emitting element to red light. Another phosphor such as blue phosphor, yellow phosphor, or orange phosphor may be used.

The light-emitting device may be a light-emitting device that emits white light, including a blue semiconductor light-emitting element, a green semiconductor light-emitting element, and a red semiconductor light-emitting element without using a phosphor.

The semiconductor light-emitting element is not particularly limited as long as the element can be used as a light-emitting element, and is not limited to a violet or blue semiconductor light-emitting element typically used, and may include a green semiconductor light-emitting element, a red semiconductor light-emitting element, or the like.

In the present embodiment, the violet semiconductor light-emitting element is a semiconductor light-emitting element in which the emission peak wavelength region is usually from 390 nm to 430 nm. The blue semiconductor light-emitting element is a semiconductor light-emitting element in which the emission peak wavelength region is usually from 430 nm to 490 nm. In the blue semiconductor light-emitting element, the lower limit of the emission peak wavelength may be 435 nm, or may be 440 nm. The upper limit of the emission peak wavelength may be 480 nm or less, may be 475 nm or less, or may be 470 nm or less.

The green semiconductor light-emitting element used together with the blue semiconductor light-emitting element may be a semiconductor light-emitting element that emits light in a green (including blue-green and yellow-green) region. The peak wavelength is usually 490 nm or more, and may be 495 nm or more, and usually 570 nm or less, and may be 560 nm or less.

The red semiconductor light-emitting element used together with the blue semiconductor light-emitting element may be a semiconductor light-emitting element that emits light in a red (including orange) region. The peak wavelength is usually 590 nm or more, and may be 600 nm or more, and is usually 780 nm or less.

The phosphor used together with the semiconductor light-emitting element is not particularly limited, and examples thereof include a blue phosphor, a green phosphor, a yellow phosphor, an orange phosphor, and a red phosphor, and these known phosphors can be used.

In the present embodiment, in order to satisfy various conditions, a combination of the phosphors used can be appropriately set, and examples of a preferred embodiment include an embodiment including at least one green phosphor and at least one red phosphor, an embodiment including at least two green phosphors, and an embodiment including at least two types of red phosphors.

The green phosphor to be used may have a peak wavelength of 490 nm or more, 495 nm or more, or 500 nm or more and 570 nm or less, 565 nm or less, or 560 nm or less.

The green phosphor to be used may have a half width of 30 nm or more, 40 nm or more, 50 nm or more, 60 nm or more, 70 nm or more, 80 nm or more, or 90 nm or more and 120 nm or less, 115 nm or less, 110 nm or less, 70 nm or less, or 60 nm or less.

The red phosphor to be used may have a peak wavelength of 590 nm or more, 600 nm or more, or 610 nm or more and 700 nm or less, 680 nm or less, or 660 nm or less.

The red phosphor to be used may have a half width of 1 nm or more or 2 nm or more and 15 nm or less or 10 nm or less, or may have a half width of 30 nm or more, 40 nm or more, 50 nm or more, 60 nm or more, 70 nm or more, 80 nm or more, or 90 nm or more and 120 nm or less, 115 nm or less or 110 nm or less.

Specific examples of the green phosphor used include a green phosphor, of which host is $Ce^{3+}$ activated aluminate, $Ce^{3+}$ activated yttrium-aluminum oxide, $Eu^{2+}$ activated alkaline earth silicate crystals, or $Eu^{2+}$ activated alkaline earth-silicon nitride. These green phosphors can normally be excited using a semiconductor light-emitting element ranging from ultraviolet to blue.

Specific examples of the $Ce^{3+}$ activated aluminate phosphor include a green phosphor represented by the following general formula (2).

$$Y_a(Ce,Tb,Lu)_b(Ga,Sc)_cAl_dO_e \qquad (2)$$

(In the general formula (2), a, b, c, d and e satisfy $a + b = 3$, $0 \leq b \leq 0.2$, $4.5 \leq c + d \leq 5.5$, $0.1 \leq c \leq 2.6$, and $10.8 \leq e \leq 13.4$.)

Note that $Ce^{3+}$ activated aluminate phosphor represented by the general formula (2) is referred to as a G-YAG phosphor.

Specific examples of $Ce^{3+}$ activated yttrium-aluminum oxide phosphor include a green phosphor represented by the following general formula (3).

$$Lu_a(Ce,Tb,Y)_b(Ga,Sc)_cAl_dO_e \qquad (3)$$

(In the general formula (3), a, b, c, d, and e satisfy $a + b = 3$, $0 \leq b \leq 0.2$, $4.5 \leq c + d \leq 5.5$, $0 \leq c \leq 2.6$, and $10.8 \leq e \leq 13.4$.)

Note that, the $Ce^{3+}$ activated yttrium-aluminum oxide phosphor represented by the general formula (3) is called "LuAG phosphor".

Other examples include green phosphors represented by the following general formula (4) and a phosphor represented by the following general formula (5).

$$M^1_a M^2_b M^3_c O_d \qquad (4)$$

(in the general formula (4), $M^1$ indicates a bivalent metallic element, $M^2$ indicates a trivalent metallic element, and $M^3$ indicates a tetravalent metallic element, and a, b, c and d satisfy $2.7 \leq a \leq 3.3$, $1.8 \leq b \leq 2.2$, $2.7 \leq c \leq 3.3$ and $11.0 \leq d \leq 13.0$.)

Note that the phosphor represented by the general formula (4) is referred to as a CSMS phosphor.

In the above-described general formula (4), $M^1$ is a bivalent metallic element, and is preferably at least one type selected from the group consisting of Mg, Ca, Zn, Sr, Cd and Ba, further preferably Mg, Ca or Zn, and particularly preferably Ca. In this case, Ca may be a single system or may be a composite system with Mg. $M^1$ may include other bivalent metallic elements.

$M^2$ is a trivalent metallic element, and is preferably at least one type selected from the group consisting of Al, Sc, Ga, Y, In, La, Gd and Lu, further preferably Al, Sc, Y or Lu, and particularly preferably Sc. In this case, Sc may be a single system or may be a composite system with Y or Lu. $M^2$ must include Ce, and $M^2$ may include other trivalent metallic elements.

$M^3$ is a tetravalent metallic element, and preferably includes at least Si. An example of a tetravalent metallic element $M^3$, other than Si, is preferably at least one type selected from the group consisting of Ti, Ge, Zr, Sn and Hf, further preferably at least one type selected from the group consisting of Ti, Zr, Sn and Hf, and particularly preferably Sn. Particularly it is preferable that $M^3$ is Si. $M^3$ may include other tetravalent metallic elements.

The lower limit of the ratio of Ce included in $M^2$ to the entire $M^2$ is preferably 0.01 or more, and more preferably 0.02 or more. Further, the upper limit of the ratio of Ce included in $M^2$ to the entire $M^2$ is preferably 0.10 or less, and more preferably 0.06 or less. Further, the lower limit of the ratio of Mg included in $M^1$ element to the entire $M^1$ is preferably 0.01 or more, and more preferably 0.03 or more. On the other hand, the upper limit is preferably 0.30 or less, and more preferably 0.10 or less.

$$M^1_a M^2_b M^3_c O_d \qquad (5)$$

(In the general formula (5), $M^1$ indicates an activator element including at least Ce, $M^2$ is a bivalent metallic element, and $M^3$ is a trivalent metallic element, and a, b, c and d satisfy $0.0001 \leq a \leq 0.2$, $0.8 \leq b \leq 1.2$, $1.6 \leq c \leq 2.4$ and $3.2 \leq d \leq 4.8$.)

Note that a phosphor represented by the general formula (5) is called "CSO phosphor".

In the above-described general formula (5), $M^1$ is an activator element contained in a host crystal, and includes at least Ce. $M^1$ can contain at least one type of bivalent to tetravalent element selected from the group consisting of Cr, Mn, Fe, Co, Ni, Cu, Ce, Pr, Nd, Sm, Eu, Tb, Dy, Ho, Er, Tm and Yb.

$M^2$ is a bivalent metallic element, and is preferably at least one type selected from the group consisting of Mg, Ca, Zn, Sr, Cd and Ba, further preferably Mg, Ca or Sr, and is particularly preferably that Ca is 50 mol% or more of the elements of $M^2$.

$M^3$ is a trivalent metallic element, and is preferably at least one type selected from the group consisting of Al, Sc, Ga, Y, In, La, Gd, Yb and Lu, and further preferably Al, Sc, Yb or Lu, more further preferably Sc, or Sc and Al, or Sc and Lu, and is particularly preferably that Sc is 50 mol% or more of the elements of $M^3$.

$M^2$ and $M^3$ are a bivalent metallic element and trivalent metallic element respectively, and a small part of $M^2$ and/or $M^3$ may be a metallic element of which valence is any one of 1, 4 and 5, and a very small amount of anions, such as a halogen element (F, Cl, Br, I), nitrogen, sulfur selenium or the like may be contained in the compound.

Furtheremore, specific examples of green phosphors using an alkaline-earth silicate crystal as a host and $Eu^{2+}$ as an activator include a phosphor represented by the following general formula (6).

$$(Ba_a Ca_b Sr_c Mg_d Eu_x) SiO_4 \qquad (6)$$

(In the general formula (6), a, b, c, d, and x satisfy $a + b + c + d + x = 2$, $1.0 \leq a \leq 2.0$, $0 \leq b < 0.2$, $0.2 \leq c \leq 1.0$, $0 \leq d < 0.2$, and $0 < x \leq 0.5$.)

Note that alkaline-earth silicate phosphor represented by the general formula (6) is referred to as a BSS phosphor.

Furtheremore, specific examples of phosphors using an alkaline-earth nitride silicate crystal as a host and $Eu^{2+}$ as an activator include a green phosphor represented by the following general formula (7).

$$(Ba, Ca, Sr, Mg, Zn, Eu)_3 Si_6 O_{12} N_2 \qquad (7)$$

Note that a phosphor represented by the general formula (7) is referred to as a BSON phosphor.

In the general formula (7), a combination of Ba, Sr and Eu is preferably among the selectable bivalent metallic elements (Ba, Ca, Sr, Mg, Zn and Eu), and the ratio of Sr to Ba is preferably 10 to 30%.

Still other examples may include a yellow phosphor such as a yttrium aluminum garnet phosphor represented by $(Y_{1-u}Gd_u)_3(Al_{1-v}Ga_v)_5O_{12}$:Ce,Eu (where u and v respectively satisfy $0 \leq u \leq 0.3$ and $0 \leq v \leq 0.5$) (this phosphor is referred to as a YAG phosphor) or a lanthanum silicon nitride phosphor represented by $Ca_{1.5x}La_{3-x}Si_6N_{11}$:Ce (where x satisfies $0 \leq x \leq 1$) (this phosphor is referred to as an LSN phosphor.) Furthermore, other examples may include a narrow band green phosphor represented by $Si_{6-z}Al_zO_zN_{8-z}$:Eu (where $0 < z < 4.2$) having $Eu^{2+}$ activated SiAlON crystal as a host (this phosphor is referred to as a β-SiAlON phosphor) and $Ca_8MgSi_4O_{16}Cl_2$:Eu (this phosphor is called a chlorosilicate phosphor. A phosphor having the same crystal structure as the chlorosilicate phosphor and in which a part of the elements is substituted is also included in the chlorosilicate phosphor).

Specific examples of a red phosphor used include phosphors using $Eu^{2+}$ as an activator and a crystal constituted by alkaline-earth silicon-nitride, α-SiAlON, or alkaline-earth silicate as a host. A red phosphor of this type can normally be excited using a semiconductor light-emitting element ranging from ultraviolet to blue.

Specific examples of phosphors using an alkaline-earth silicon-nitride crystal as a host include a phosphor represented by $CaAlSiN_3$:Eu (this phosphor is referred to as a CASN phosphor), a phosphor represented by $(Ca,Sr,Ba,Mg)AlSiN_3$:Eu and/or $(Ca,Sr,Ba)AlSiN_3$:Eu (this phosphor is referred to as a SCASN phosphor), a phosphor represented by $(CaAlSiN_3)_{1-x}(Si_2N_2O)_x$:Eu (where x satisfies $0 < x < 0.5$) (this phosphor is referred to as a CASON phosphor), a phosphor represented by $(SrCa,Ba)_2Al_xSi_{5-x}O_xN_{8-x}$:Eu (where $0 \leq x \leq 2$), and a phosphor represented by $Eu_y(Sr,Ca,Ba)_{1-y}$:$Al_{1+x}Si_{4-x}O_xN_{7-x}$ (where $0 \leq x < 4$, $0 \leq y < 0.2$).

Other examples include a $Mn^{4+}$-activated fluoride complex phosphor. A $Mn^{4+}$-activated fluoride complex phosphor is a phosphor which uses $Mn^{4+}$ as an activator and a fluoride complex salt of an alkali metal, amine, or an alkaline-earth metal as a host crystal. Fluoride complex salts which form the host crystal include those whose coordination center is a trivalent metal (B, Al, Ga, In, Y, Sc or a lanthanoid), a tetravalent metal (Si, Ge, Sn, Ti, Zr, Re or Hf), and a pentavalent metal (V, P, Nb or Ta), and the number of fluorine atoms coordinated around the center ranges from 5 to 7.

Specific examples of the $Mn^{4+}$-activated fluoride complex phosphor include $A_{2+x}M_yMn_zF_n$ (where A is Na and/or K; M is Si and Al; and $-1 \leq x \leq 1$ and $0.9 \leq y + z \leq 1.1$ and $0.001 \leq z \leq 0.4$ and $5 \leq n \leq 7$) which uses a hexafluoro complex of an alkali metal as a host crystal. Among the above, specific examples thereof include phosphors in which A is one or more types selected from K (potassium) or Na (sodium) and M is Si (silicon), Ti (titanium) or Ge (germanium), such as $K_2SiF_6$:Mn (this phosphor is referred to as a KSF phosphor) or $K_2Si_{1-x}Na_xAl_xF_6$:Mn (this phosphor is referred to as a KSNAF phosphor) that is obtained by replacing a part (favorably, 10 mol% or less) of the components of $K_2SiF_6$:Mn with Al and Na.

Other examples include a phosphor represented by the following general formula (8) and a phosphor represented by the following general formula (9).

$$(La_{1-x-y}Eu_xLn_y)_2O_2S \qquad (8)$$

(In the general formula (8), x and y denote numbers respectively satisfying $0.02 \leq x \leq 0.50$ and $0 \leq y \leq 0.50$, and Ln denotes at least one trivalent rare-earth element among Y, Gd, Lu, Sc, Sm, and Er)

Note that a lanthanum oxysulfide phosphor represented by the general formula (8) is referred to as a LOS phosphor.

$$(k-x)MgO \cdot xAF_2 \cdot GeO_2 : yMn^{4+} \qquad (9)$$

(In the general formula (9), k, x, and y denote numbers respectively satisfying $2.8 \leq k \leq 5$, $0.1 \leq x \leq 0.7$, and $0.005 \leq y \leq 0.015$, and A is any of calcium (Ca), strontium (Sr), barium (Ba), zinc (Zn), and a mixture consisted of these elements)

Note that a germanate phosphor represented by the general formula (9) is referred to as an MGOF phosphor.

The light-emitting device according to an embodiment of the present invention is a light-emitting device that can realize natural, vivid, highly visible and comfortable color appearance, and therefore is preferably a light-emitting device which satisfies all of the following requirements I to III. In understanding the following requirements, the contents described in Patent Documents 1 to 3 can be referred to. Unless otherwise noted, light emitted from a light-emitting device is light emitted at room temperature conditions.

Condition I:

Condition I is that the distance $D_{uv}$ from the black body radiation locus satisfies $-0.0200 \leq D_{uv} < 0$. When the distance $D_{uv}$ takes a slight negative value, it tends to be easy to realize a light-emitting device that can realize a natural, vivid, highly visible and comfortable color appearance.

The distance $D_{uv}$ may be -0.0200 or more, and particularly from the viewpoint of achieving a natural appearance, may be -0.0150 or more, and may be -0.0100 or more.

Condition II:

Condition II is that the color saturation difference in the CIE 1976 $L^*a^*b^*$ color space of the Munsell renotation color samples between light emitted from the light-emitting device of the present embodiment and the reference light at the corresponding correlated color temperature is small in all color samples. Specifically, the Condition II is as follows.

Letting an $a^*$ value and a $b^*$ value in the following CIE 1976 $L^*a^*b^*$ color space of 15 Munsell renotation color samples of from #01 to #15 listed below when mathematically assuming illumination by light emitted from a light-emitting device in the radiant direction be $a^*_{nSSL}$ and $b^*_{nSSL}$ (where n is a natural number from 1 to 15), respectively,

and an $a^*$ value and a $b^*$ value in the CIE 1976 $L^*a^*b^*$ color space of 15 Munsell renotation color samples when mathematically assuming illumination with reference light selected according to the correlated color temperature $T_{SSL}(K)$ of light emitted in the radiant direction be $a^*_{nref}$ and $b^*_{nref}$ (where n is a natural number from 1 to 15), respectively, the saturation difference $\Delta C_n$ satisfies $-3.0 \leq \Delta C_n \leq 10.0$ (n is a natural number from 1 to 15),

where

$$\Delta C_n = \sqrt{\{(a^*_{nSSL})^2 + (b^*_{nSSL})^2\}} - \sqrt{\{(a^*_{nref})^2 + (b^*_{nref})^2\}},$$

with the 15 Munsell renotation color samples being:

| #01 | 7.5P | 4/10 |
| #02 | 10PB | 4/10 |
| #03 | 5PB | 4/12 |
| #04 | 7.5B | 5/10 |
| #05 | 10BG | 6/8 |
| #06 | 2.5BG | 6/10 |
| #07 | 2.5G | 6/12 |
| #08 | 7.5GY | 7/10 |
| #09 | 2.5GY | 8/10 |
| #10 | 5Y | 8.5/12 |
| #11 | 10YR | 7/12 |
| #12 | 5YR | 7/12 |
| #13 | 10R | 6/12 |
| #14 | 5R | 4/14 |
| #15 | 7.5RP | 4/12 |

The saturation difference $\Delta C_n$ may be -3.0 or more, -2.0 or more, -1.5 or more, -1.0 or more or 0 or more and may be 10.0 or less, 9.0 or less or 8.0 or less.

Condition III:

Condition III is that the average of the color saturation differences in the CIE 1976 $L^*a^*b^*$ color space of the Munsell renotation color samples between light emitted from the light-emitting device of the present embodiment and the reference light at the corresponding correlated color temperature takes a positive specific value.

Specifically, $\Delta C_{ave}$ representing the average of the $\Delta C_n$ (n is an integer from 1 to 15) satisfies $0.5 \leq \Delta C_{ave} \leq 6.0$.

The average saturation difference $\Delta C_{ave}$ may be 0.5 or more or 0.53 or more and 6.0 or less, 5.0 or less, 4.0 or less, 3.5 or less or 3.0 or less.

The present inventors focused on the appearance of skin with the above-described light-emitting device that can realize natural, vivid, highly visible and comfortable color appearance, and found that the saturation ($\Delta C_{14}$) of #14 and the saturation ($\Delta C_{11}$) of #11 in the Munsell renotation color samples are factors which significantly affect the appearance of skin with the light-emitting device that can realize natural, vivid, highly visible and comfortable color appearance.

In the present embodiment, in addition to satisfying the above-described Conditions I to III, in order to achieve favorable appearance of skin, it is preferable to satisfy the following Conditions IV to V.

Condition IV:

Condition IV is that the saturation ($\Delta C_{14}$) of #14 in the Munsell renotation color samples takes zero to a specific positive value. Specifically, the saturation ($\Delta C_{14}$) of #14 in the Munsell renotation color samples satisfies $0 \leq \Delta C_{14} \leq 8.0$.
$\Delta C_{14}$ may be 0 or more, or more than 0, and 7.5 or less, 7.0 or less, 6.5 or less or 6.0 or less.

Condition V:

The condition V is that, when the value of the saturation ($\Delta C_{14}$) of #14 and the value of the saturation ($\Delta C_{11}$) of #11 in the Munsell renotation color samples are compared, the values are almost the same or $\Delta C_{14}$ takes a larger value. Specifically, the ratio ($\Delta C_{14}/\Delta C_{11}$) of the saturation ($\Delta C_{14}$) of #14 in the Munsell renotation color samples to the saturation ($\Delta C_{11}$) of #11 in the Munsell renotation color samples satisfies $0.1 \leq \Delta C_{14}/\Delta C_{11} \leq 8.0$.
$\Delta C_{14}/\Delta C_{11}$ may be 0.10 or more, 0.15 or more, 0.20 or more, 0.3 or more, 0.4 or more, 0.5 or more or 0.6 or more, and may be 8.0 or less, 7.0 or less, 6.0 or less, or 5.0 or less, 4.0 or less, 3.0 or less or 2.0 or less.
Furthermore, in the present embodiment, from the viewpoint of achieving favorable appearance of skin, it is preferable to satisfy the following Conditions VI to VIII. Condition IX may be satisfied.

Condition VI:

Condition VI is that the saturation ($\Delta C_{12}$) of #12 in the Munsell renotation color samples takes zero or a positive specific value. Specifically, the saturation ($\Delta C_{12}$) of #12 in the Munsell renotation color samples satisfies $0 \leq \Delta C_{12} \leq 8.0$.
$\Delta C_{12}$ may be 0 or more or more than 0, and may be 7.5 or less, 7.0 or less, 6.5 or less or 6.0 or less.

Condition VII:

Condition VII is that the saturation ($\Delta C_{13}$) of #13 in the Munsell renotation color samples takes zero or a positive specific value. Specifically, the saturation ($\Delta C_{13}$) of #13 in the Munsell renotation color samples satisfies $0 \leq \Delta C_{13} \leq 8.0$.
$\Delta C_{13}$ may be 0 or more, or more than 0, and may be 7.5 or less, 7.0 or less, 6.5 or less or 6.0 or less.
Since Conditions VI and VII are also factors affecting the appearance of skin, it is preferable to satisfy Condition VI or Condition VII, and it is more preferable to satisfy Condition VI and Condition VII.

Condition VIII:

Condition VIII is that the visible light region is divided into a short wavelength region, a medium wavelength region, and a long wavelength region, and the integrated value of the difference between the light spectrum emitted from a light-emitting device and the spectrum of the reference light at the corresponding correlated color temperature in each region takes a specific value. Specifically, letting the spectral distribution of light emitted from the light-emitting device in the radiant direction be $\varphi_{SSL}(\lambda)$, the spectral power distribution of reference light selected according to the correlated color temperature $T_{SSL}(K)$ of light emitted from the light-emitting device in the radiant direction be $\varphi_{ref}(\lambda)$, tristimulus values of light emitted from the light-emitting device in the radiant direction be ($X_{SSL}$, $Y_{SSL}$, $Z_{SSL}$), and tristimulus values of reference light selected according to the correlated color temperature $T_{SSL}(K)$ of light emitted from the light-emitting device in the radiant direction be ($X_{ref}$, $Y_{ref}$, $Z_{ref}$), and

defining normalized spectral power distribution $S_{SSL}(\lambda)$ of light emitted from the light-emitting device in the radiant direction, normalized spectral power distribution $S_{ref}(\lambda)$ of reference light selected according to the correlated color temperature $T_{SSL}(K)$ of light emitted from the light-emitting device in the radiant direction, and the difference $\Delta S(\lambda)$ of these normalized spectral power distributions as

$$S_{SSL}(\lambda) = \varphi_{SSL}(\lambda)/Y_{SSL},$$

$$S_{ref}(\lambda) = \varphi_{ref}(\lambda)/Y_{ref},$$

and

$$\Delta S(\lambda) = S_{ref}(\lambda) - S_{SSL}(\lambda),$$

respectively,

letting the wavelength giving the local maximum value of $S_{SSL}(\lambda)$ at the longest wavelength in the wavelength range of from 380 nm to 780 nm be $\lambda_R$ (nm), when a wavelength $\Lambda 4$ giving the value of $S_{SSL}(\lambda_R)/2$ on the long wavelength side of $\lambda_R$ exists,

the indicator $A_{cg}$ represented by the following Formula (1-1) is $-30 \leq A_{cg} \leq 120$,

while letting the wavelength giving the local maximum value of $S_{SSL}(\lambda)$ at the longest wavelength in the wavelength range of from 380 nm to 780 nm be $\lambda_R$ (nm), when a wavelength $\Lambda 4$ giving the value of $S_{SSL}(\lambda_R)/2$ on the long wavelength side of $\lambda_R$ does not exist,

the indicator $A_{cg}$ represented by the following Formula (1-2) is $-30 \leq A_{cg} \leq 120$.

[Math 3]

$$A_{cg} = \int_{380}^{495} \Delta S(\lambda) d\lambda + \int_{495}^{590} (-\Delta S(\lambda)) d\lambda + \int_{590}^{\Lambda 4} \Delta S(\lambda) d\lambda \qquad (1-1)$$

[Math 4]

$$A_{cg} = \int_{380}^{495} \Delta S(\lambda) d\lambda + \int_{495}^{590} (-\Delta S(\lambda)) d\lambda + \int_{590}^{780} \Delta S(\lambda) d\lambda \qquad (1-2)$$

The indicator $A_{cg}$ may be -30 or more, -20 or more, -10 or more or 0 or more, and may be 120 or less, 110 or less or 100 or less.

Condition IX:

Condition IX is that the values of $\Delta C_{14}$ and $\Delta C_{11}$, which are factors that significantly affect the appearance of skin, do not deviate significantly. Specifically, the difference ($\Delta C_{14}$ - $\Delta C_{11}$) between the saturation ($\Delta C_{14}$) of #14 in the Munsell renotation color samples and the saturation ($\Delta C_{11}$) of #11 in the Munsell renotation color samples satisfies $-1.6 \leq \Delta C_{14}$ - $\Delta C_{11} \leq 4.0$.

The difference ($\Delta C_{14}$ - $\Delta C_{11}$) may be -1.6 or more, -1.5 or more, -1.0 or more, -0.5 or more, 0 or more, or larger than 0, and may be 4.0 or less, 3.5 or less or 3.0 or less.

The parameters described in Condition I to Condition IX can be adjusted to desired values by the methods described in Patent Documents 1 to 3. For example, various means can be considered to reduce $D_{uv}$ from 0 to an appropriate negative value. For example, in a light-emitting device provided with a blue LED, the peak wavelength of a blue LED can be further moved to a shorter wavelength side, when using a red LED or red phosphor, the peak wavelength thereof can be further shifted to a longer wavelength side, when using a green LED or green phosphor, the peak wavelength thereof can be offset from 555 nm, or the like. Furthermore, the relative emission intensity of a blue LED can be increased, the relative emission intensity of a red LED or red phosphor can be increased, the relative emission intensity of a green LED or green phosphor can be decreased, or the like. In order to change $D_{uv}$ to the positive side, the reverse operation to the above description may be performed.

In addition, in particular, $\Delta C_{11}$ and $\Delta C_{14}$ described in the conditions IV to V can be set to desired values by using a green phosphor capable of realizing, in the emission spectrum, increasing the emission intensity on the short wavelength side of the green emission region and/or decreasing the emission intensity on the long wavelength side of the green emission region. $\Delta C_{12}$ and $\Delta C_{13}$ described in the conditions VI and VII can be set to desired values by adjusting the balance between the spectrum in the green region and the spectrum in the red region in the emission spectrum, specifically, by appropriately adjusting the red light emission region and the light emission intensity formed by the spectrum emitted from a red LED or red phosphor with respect to the green light emission region and the green light emission intensity formed by the spectrum emitted from a green LED or green phosphor.

As described above, the light-emitting device according to the present embodiment is a light-emitting device that can realize natural, vivid, highly visible and comfortable color appearance, and further can realize light that can improve the appearance of skin. This light-emitting device is realized from a different approach from a conventionally developed light source for improving the appearance of skin, and can realize favorable appearance of skin in the present embodiment even if *R9* which is a special color rendering index for red, for example, is not a high value. For example, even when R9 is 90 or less or 85 or less, such a light-emitting device can realize favorable appearance of skin.

In the present embodiment, the correlated color temperature CCT of light emitted from the light-emitting device is not particularly limited, and may be substantially the same value as a light-emitting device in general lighting, and is usually 1,600 K or more, and may be 2,000 K or more or 2,400 K or more. The correlated color temperature is usually 7,000 K or less, and may be 6500 K or less or 6,000 K or less. More specifically, light emitted from the light-emitting device may be a bulb color or a warm white color of about from 2,700 K to 4,000 K, or a daylight white of about from 4,500 K to 6,000 K.

According to the present invention, by applying the above-described findings obtained in the light-emitting device, a method of illuminating a target illumination object in such a manner to satisfy the above-described Conditions, such as Conditions II to V, a method of designing illumination satisfying the above-described Conditions, such as Conditions I to V, and the like are also provided. Other examples provided include a method of illuminating to satisfy, for example, Conditions II to V using a plurality of light-emitting devices and a method of illuminating in such a manner to satisfy, for example, Conditions II to V through a wavelength control element such as a filter. Those skilled in the art can fully understand the contents of these methods by referring to the above description.

Furthermore, the present invention also includes realization of light which can satisfy the above-described Conditions, realize natural, vivid, highly visible and comfortable color appearance, and further improve the appearance of skin by arranging a wavelength control element such as a filter on the subject side of a light-emitting device. Examples of a typical wavelength control element include a cut filter for reducing the wavelength intensity of a specific wavelength range by reflection and/or absorption, but are not limited thereto, and may also include a lens provided with a light condensing function or a light diffusing function.

In other words, the present invention can be
an illumination device including:
at least a semiconductor light-emitting element as a light-emitting element; and
a light-emitting device capable of emitting light satisfying the requirements defined in the above-described Conditions I to V in the main radiant direction, and a wavelength control element arranged on the subject side of the light-emitting device

Hereinafter, the present invention will be described more specifically by showing experiments conducted by the present inventors.

<Experiment 1: Relationship between Color Rendering Property and Color Saturation, and Relationship between Color Rendering Property and Appearance of Skin>

First, experiments were conducted on the relationship between a widely used color rendering index *Ra* and the appearance of skin. Specifically, using a light source A having an *Ra* of 83, a light source B having an *Ra* of 93, and a light source C having an *Ra* of 98, the saturation of each color in the Munsell renotation color chart was calculated for light emitted from each light source. The skin was irradiated with each of the light sources A to C, and the results are summarized in Table 1.

The appearance of skin was measured as follows.

Using each light source, the skin of a plurality of people was irradiated, and comparative evaluation of the light source was performed for the appearance of the skin. The evaluation was rated from 1 to 4 in four stages, and when skin dullness, dark spots, or the like were less emphasized and the skin appeared to have more natural and beautiful color, the evaluation was rated higher. Specific criteria are as follows.

1: Dull skin, noticeable spots on the skin (unnatural)

2: Dull skin color

3: Bright and beautiful skin color

4: Considerably favorable appearance of skin color, and natural and beautiful skin color (natural)

[Table 1]

Table 1

| | Light source A | Light source B | Light source C |
|---|---|---|---|
| Correlated Color Temperature | 2983 K | 3057 K | 3067 K |
| Duv | 0.0007 | -0.0008 | 0.0012 |
| Ra | 83 | 93 | 98 |
| R9 | 11 | 70 | 95 |
| Acg | 110.9 | 141.2 | 147.9 |
| $\Delta C_{ave}$ | -1.20 | 0.19 | 0.06 |
| $\Delta C_{14/11}$ | -25.32 | -4.29 | 0.63 |
| $\Delta C_{11}$ | 0.32 | 0.63 | -0.57 |
| $\Delta C_{12}$ | -0.73 | -0.10 | -0.52 |
| $\Delta C_{13}$ | -2.35 | -0.75 | -0.21 |
| $\Delta C_{14}$ | -8.21 | -2.72 | -0.36 |
| $\Delta C_{15}$ | -7.19 | -2.46 | -0.44 |
| Evaluation of appearance of skin | 1 | 2 | 2 |

From Table 1, it can be understood that as the *Ra* increased, the variation in the saturation of each color in the Munsell renotation color chart converged to zero. The appearance of skin was not affected by the magnitude of *Ra,* and the skin color appeared to be dull when using any light source. This was considered to be due to the fact that the value of $\Delta C_{14}$ indicating the color saturation of red was lowered.

<Experiment 2: Relationship between Special Color Rendering Property *R9* and Color Saturation, and Relationship between Color Rendering and Appearance of Skin>

Next, experiments were conducted on the relationship between the correlated color temperature and the special color rendering index *R9* described in Patent Document 6 and the appearance of skin. Specifically, using a light source D with a correlated color temperature of about 2,700 K and *R9* of 74, a light source E with a correlated color temperature of about 3,500 K and *R9* of 83 and a light source F with a correlated color temperature of about 5,000 K and *R9* of 98, the saturation of each color in the Munsell renotation color chart was calculated for light emitted from each light source. A skin was irradiated using each of light sources D to F, and the results are summarized in Table 2.

[Table 2]

Table 2

| | Light source D | Light source E | Light source F |
|---|---|---|---|
| Correlated Color Temperature | 2707 K | 3510 K | 5024 K |
| Duv | -0.0044 | -0.0002 | -0.0058 |
| Ra | 94 | 95 | 95 |
| R9 | 74 | 83 | 98 |
| Acg | 135.9 | 144.8 | 93.8 |
| $\Delta C_{ave}$ | 1.39 | 0.17 | 1.14 |
| $\Delta C_{14/11}$ | -0.66 | -7.98 | -0.42 |
| $\Delta C_{11}$ | 3.16 | 0.18 | 1.51 |

(continued)

|  | Light source D | Light source E | Light source F |
|---|---|---|---|
| Correlated Color Temperature | 2707 K | 3510 K | 5024 K |
| $\Delta C_{12}$ | 1.82 | -0.32 | 0.31 |
| $\Delta C_{13}$ | 0.52 | -0.60 | -0.56 |
| $\Delta C_{14}$ | -2.09 | -1.45 | -0.64 |
| $\Delta C_{15}$ | -2.42 | -1.34 | -0.38 |
| Evaluation of appearance of skin | 2 | 2 | 2 |

From Table 2, it can be understood that as $R9$ increased, $\Delta C_{14}$ increased. However, even when $R9$ was a very high value of 98, the skin color appeared dull. This was considered to be due to the fact that the value of $\Delta C_{14}$ indicating a color saturation of red was still a negative value and the ratio $\Delta C_{14}/\Delta C_{11}$ ($\Delta C_{14/11}$) of the value of $\Delta C_{14}$ to the value of $\Delta C_{11}$ was a negative value.

<Experiment 3: Relationship between High Color Saturation Light Source and Appearance of Skin>

Next, experiments were conducted to see what the appearance of skin would look like by using the light-emitting devices capable of realizing a natural, vivid, highly visible and comfortable color appearance described in Patent Documents 1 to 3, that is, by using a light source having a high $Ra$ and improved color saturation throughout the Munsell renotation color chart. Specifically, using a light source G having an average $\Delta C_{ave}$ indicating an average color saturation of the Munsell renotation color chart of 1.70 and a special color rendering index $R9$ of 89, a light source H having a $\Delta C_{ave}$ of 1.83 and an $R9$ of 87 and a light source I having a $\Delta C_{ave}$ of 1.70 and an $R9$ of 92, the saturation of each color in the Munsell renotation color chart was calculated for light emitted from each light source. A skin was irradiated with each of the light sources G to I, and the results are summarized in Table 3.

[Table 3]

Table 3

|  | Light source G | Light source H | Light source I |
|---|---|---|---|
| Correlated Color Temperature | 3236 K | 3425 K | 4219 K |
| Duv | -0.0063 | -0.0078 | -0.0078 |
| Ra | 96 | 95 | 94 |
| R9 | 89 | 87 | 92 |
| Acg | 60.0 | 53.0 | 97.7 |
| $\Delta C_{ave}$ | 1.70 | 1.83 | 1.70 |
| $\Delta C_{14/11}$ | 0.50 | 0.53 | 0.23 |
| $\Delta C_{11}$ | 2.16 | 2.23 | 1.45 |
| $\Delta C_{12}$ | 1.47 | 1.46 | 0.48 |
| $\Delta C_{13}$ | 1.19 | 1.14 | 0.11 |
| $\Delta C_{14}$ | 1.08 | 1.18 | 0.34 |
| $\Delta C_{15}$ | 0.47 | 0.62 | 0.49 |
| Evaluation of appearance of skin | 3 | 3 | 3 |

From Table 3, by increasing the overall saturation, natural, vivid, highly visible and comfortable color appearance can be realized, and although the appearance of skin was improved, it can not be said that the appearance was sufficiently good. The reason was considered to be that because the value of $\Delta C_{11}$ was much larger than the value of $\Delta C_{14}$, favorable appearance of skin could not be achieved. For this reason, in Experiment 4, an attempt was made to increase the value of $\Delta C_{14}$ and to increase the value of $\Delta C_{14/11}$.

<Experiment 4: Relationship between Light Source Having High Color Saturation and High $\Delta C_{14}$ and Appearance of Skin>

Next, an experiment was conducted using a light-emitting device that can realize natural, vivid, highly visible and comfortable color appearance in which the type and amount of phosphors used in the light-emitting device are adjusted in such a manner that the value of $\Delta C_{14}$ was high. Specifically, using a light source J having a $\Delta C_{ave}$ of 1.61 indicating an average color saturation of the Munsell renotation color chart, a special color rendering index $R9$ of 83, a $\Delta C_{11}$ value of 1.67 and a $\Delta C_{14}$ value of 1.73, a light source K having a $\Delta C_{ave}$ of 1.33, a special color rendering index $R9$ of 83, a $\Delta C_{11}$ value of 0.87 and a $\Delta C_{14}$ value of 1.43, a light source L having a $\Delta C_{ave}$ of 1.28, a special color rendering index $R9$ of 80, a value of $\Delta C_{11}$ of 1.15 and a $\Delta C_{14}$ value of 1.35 and a light source M having a $\Delta C_{ave}$ of 3.36, a special color rendering index $R9$ of 40, a $\Delta C_{11}$ value of 2.29 and a $\Delta C_{14}$ value of 5.53, the saturation of each color in the Munsell renotation color chart was calculated for light emitted from each light source. A skin was irradiated with each of the light sources J to M, and the results are summarized in Table 4.

[Table 4]

Table 4

|  | Light source J | Light source K | Light source L | Light source M |
|---|---|---|---|---|
| Correlated Color Temperature | 3182 K | 4166 K | 5228 K | 3206 K |
| Duv | -0.0046 | -0.0046 | -0.0046 | -0.0076 |
| Ra | 95 | 96 | 96 | 87 |
| R9 | 83 | 83 | 80 | 40 |
| Acg | 71.3 | 104.4 | 78.9 | -13.9 |
| $\Delta C_{ave}$ | 1.61 | 1.33 | 1.28 | 3.36 |
| $\Delta C_{14/11}$ | 1.04 | 1.64 | 1.18 | 2.41 |
| $\Delta C_{11}$ | 1.67 | 0.87 | 1.15 | 2.29 |
| $\Delta C_{12}$ | 1.23 | 0.41 | 0.60 | 1.86 |
| $\Delta C_{13}$ | 1.25 | 0.55 | 0.45 | 2.56 |
| $\Delta C_{14}$ | 1.73 | 1.43 | 1.35 | 5.53 |
| $\Delta C_{15}$ | 1.08 | 1.10 | 0.93 | 4.54 |
| Evaluation of appearance of skin | 4 | 4 | 4 | 3 |

It can be understood from Table 4 that a light source that can realize natural, vivid, highly visible and comfortable color appearance, and also achieves sufficiently favorable appearance of skin can be provided by increasing the value of $\Delta C_{14}$ and increasing the value of $\Delta C_{14/11}$. For this reason, it can be understood that, in order to achieve favorable appearance of skin, it is necessary to set particularly the value of $\Delta C_{14}$ to a positive value, particularly to from 0 to 8 and to set the value of $\Delta C_{14/11}$ to a positive value, particularly to from 0.1 to 8.

<Experiment 5: Luminaire Equipped with High Color Saturation and High $\Delta C_{14}$ Light Source>

A lighting test was conducted on an assumption that light sources J, K and L, which were light sources capable of realizing the above-described natural, vivid, highly visible and comfortable color appearance and sufficiently improving the appearance of skin, were mounted on a luminaire.

Specifically, assuming long-term illumination, the current and voltage were adjusted in such a manner that the junction operation temperature of a semiconductor light-emitting element included in a light-emitting device was equivalent to 85°C, and a test was conducted using luminaires A, B and C equipped with light sources J, K and L, respectively.

The results are shown in Table 5. Even when operated as a luminaire, these light sources can realize a natural, vivid, highly visible and comfortable color appearance, and emit a light that achieved sufficiently favorable appearance of skin.

[Table 5]

Table 5

| | Luminaire A (Light source J) | Luminaire B (Light source K) | Luminaire C (Light source L) |
|---|---|---|---|
| Correlated Color Temperature | 3069 K | 3992 K | 5019 K |
| Duv | -0.0057 | -0.0060 | -0.0062 |
| Ra | 96 | 96 | 94 |
| R9 | 92 | 88 | 76 |
| Acg | 84.1 | 97.1 | 40.8 |
| $\Delta C_{ave}$ | 1.80 | 1.41 | 1.17 |
| $\Delta C_{14/11}$ | 0.35 | 0.75 | 1.20 |
| $\Delta C_{11}$ | 2.32 | 1.21 | 1.35 |
| $\Delta C_{12}$ | 1.57 | 0.65 | 1.08 |
| $\Delta C_{13}$ | 1.20 | 0.57 | 0.96 |
| $\Delta C_{14}$ | 0.82 | 0.90 | 1.63 |
| $\Delta C_{15}$ | 0.27 | 0.63 | 0.85 |
| Evaluation of appearance of skin | 4 | 4 | 4 |

**Claims**

1. A light-emitting device comprising at least a semiconductor light-emitting element as a light-emitting element, and capable of emitting light satisfying the requirements defined in the following Conditions I to V in the main radiant direction.

   Condition I:
   The distance $D_{uv}$ from the black body radiation locus satisfies

   $$-0.0200 \leq D_{uv} < 0.$$

   Condition II:
   Letting an $a*$ value and a $b*$ value in the following CIE 1976 $L*a*b*$ color space of 15 Munsell renotation color samples of from #01 to #15 listed below when mathematically assuming illumination by light emitted from the light-emitting device in the radiant direction be $a*_{nSSL}$ and $b*_{nSSL}$ (where n is a natural number from 1 to 15), respectively,
   and an $a*$ value and a $b*$ value in the CIE 1976 $L*a*b*$ color space of 15 Munsell renotation color samples when mathematically assuming illumination with reference light selected according to the correlated color temperature $T_{SSL}(K)$ of light emitted in the radiant direction be $a*_{nref}$ and $b*_{nref}$ (where n is a natural number from 1 to 15), respectively, the saturation difference $\Delta C_n$ satisfies

   $$-3.0 \leq \Delta C_n \leq 10.0 \text{ (n is a natural number from 1 to 15)}.$$

(n is a natural number from 1 to 15).
Condition III:
$\Delta C_{ave}$ representing the average of the $\Delta C_n$ (n is an integer from 1 to 15) satisfies

$$0.5 \leq \Delta C_{ave} \leq 6.0.$$

Condition IV:
The saturation ($\Delta C_{14}$) of #14 in the Munsell renotation color samples satisfies

$$0 \leq \Delta C_{14} \leq 8.0.$$

Condition V:
The ratio ($\Delta C_{14}/\Delta C_{11}$) of the saturation ($\Delta C_{14}$) of #14 in the Munsell renotation color samples to the saturation ($\Delta C_{11}$) of #11 in the Munsell renotation color samples satisfies

$$0.1 \leq \Delta C_{14}/\Delta C_{11} \leq 8.0,$$

where

$$\Delta C_n = \sqrt{\{(a^*_{nSSL})^2 + (b^*_{nSSL})^2\}} - \sqrt{\{(a^*_{nref})^2 + (b^*_{nref})^2\}},$$

with the 15 Munsell renotation color samples being:

| | | |
|---|---|---|
| #01 | 7.5P | 4/10 |
| #02 | 10PB | 4/10 |
| #03 | 5PB | 4/12 |
| #04 | 7.5B | 5/10 |
| #05 | 10BG | 6/8 |
| #06 | 2.5BG | 6/10 |
| #07 | 2.5G | 6/12 |
| #08 | 7.5GY | 7/10 |
| #09 | 2.5GY | 8/10 |
| #10 | 5Y | 8.5/12 |
| #11 | 10YR | 7/12 |
| #12 | 5YR | 7/12 |
| #13 | 10R | 6/12 |
| #14 | 5R | 4/14 |
| #15 | 7.5RP | 4/12 |

2. The light-emitting device according to claim 1, wherein
$D_{uv}$ defined in the Condition I satisfies $-0.0150 \leq D_{uv} < 0$,
the $\Delta C_n$ defined by the Condition II satisfies $-2.0 \leq \Delta C_n \leq 10.0$, and
the $\Delta C_{ave}$ defined by the Condition III satisfies $0.5 \leq \Delta C_{ave} \leq 4.0$.

3. The light-emitting device according to claim 1 or 2, wherein $\Delta C_{14}/\Delta C_{11}$ defined by the Condition V satisfies $0.1 \leq \Delta C_{14}/\Delta C_{11} \leq 3.0$.

4. The light-emitting device according to claim 1 or 2, wherein $\Delta C_{14}/\Delta C_{11}$ defined by the Condition V satisfies $0.1 \leq \Delta C_{14}/\Delta C_{11} \leq 2.0$.

**5.** The light-emitting device according to any one of claims 1 to 4, further satisfying Condition VI.

Condition VI:
The saturation ($\Delta C_{12}$) of #12 in the Munsell renotation color samples satisfies $0 \leq \Delta C_{12} \leq 8.0$.

**6.** The light-emitting device according to any one of claims 1 to 4, further satisfying Condition VII.

Condition VII:
The saturation ($\Delta C_{13}$) of #13 in the Munsell renotation color samples satisfies $0 \leq \Delta C_{13} \leq 8.0$.

**7.** The light-emitting device according to claim 5 or 6, satisfying both the Condition VI and the Condition VII.

**8.** The light-emitting device according to any one of claims 1 to 7, further satisfying Condition VIII.

Condition VIII:

Letting the spectral distribution of light emitted from the light-emitting device in the radiant direction be $\varphi_{SSL}(\lambda)$, the spectral power distribution of reference light selected according to the correlated color temperature $T_{SSL}(K)$ of light emitted from the light-emitting device in the radiant direction be $\varphi_{ref}(\lambda)$, tristimulus values of light emitted from the light-emitting device in the radiant direction be ($X_{SSL}$, $Y_{SSL}$, $Z_{SSL}$), and tristimulus values of reference light selected according to the correlated color temperature $T_{SSL}(K)$ of light emitted from the light-emitting device in the radiant direction be ($X_{ref}$, $Y_{ref}$, $Z_{ref}$), and
defining normalized spectral power distribution $S_{SSL}(\lambda)$ of light emitted from the light-emitting device in the radiant direction, normalized spectral power distribution $S_{ref}(\lambda)$ of reference light selected according to the correlated color temperature $T_{SSL}(K)$ of light emitted from the light-emitting device in the radiant direction, and the difference $\Delta S(\lambda)$ of these normalized spectral power distributions as

$$S_{SSL}(\lambda) = \varphi_{SSL}(\lambda)/Y_{SSL},$$

$$S_{ref}(\lambda) = \varphi_{ref}(\lambda)/Y_{ref},$$

and

$$\Delta S(\lambda) = S_{ref}(\lambda) - S_{SSL}(\lambda),$$

respectively,
letting the wavelength giving the local maximum value of $S_{SSL}(\lambda)$ at the longest wavelength in the wavelength range of from 380 nm to 780 nm be $\lambda_R$ (nm), when a wavelength $\Lambda4$ giving the value of $S_{SSL}(\lambda_R)/2$ on the long wavelength side of $\lambda_R$ exists,
the indicator $A_{cg}$ represented by the following Formula (1-1) is $-30 < A_{cg} \leq 120$,
while letting the wavelength giving the local maximum value of $S_{SSL}(\lambda)$ at the longest wavelength in the wavelength range of from 380 nm to 780 nm be $\lambda_R$ (nm), when a wavelength $\Lambda4$ giving the value of $S_{SSL}(\lambda_R)/2$ on the long wavelength side of $\lambda_R$ does not exist,
the indicator $A_{cg}$ represented by the following Formula (1-2) is $-30 < A_{cg} \leq 120$.
[Math 1]

$$A_{cg}=\int_{380}^{495}\Delta S(\lambda)d\lambda+\int_{495}^{590}(-\Delta S(\lambda))d\lambda+\int_{590}^{\Lambda4}\Delta S(\lambda)d\lambda \qquad (1-1)$$

[Math 2]

$$A_{cg} = \int_{380}^{495} \Delta S(\lambda) d\lambda + \int_{495}^{590} (-\Delta S(\lambda)) d\lambda + \int_{590}^{780} \Delta S(\lambda) d\lambda \qquad (1-2)$$

9. The light-emitting device according to any one of claims 1 to 8, comprising at least one green phosphor and at least one red phosphor.

10. The light-emitting device according to claim 9, wherein the green phosphor comprises a LuAG phosphor.

11. The light-emitting device according to claim 9 or 10, wherein the red phosphor comprises a CASN phosphor.

12. The light-emitting device according to any one of claims 1 to 8, comprising at least two types of green phosphors.

13. The light-emitting device according to claim 12, wherein the at least two green phosphors are selected from an LuAG phosphor, a $\beta$-SiAlON phosphor, and a chlorosilicate phosphor, and comprise at least an LuAG phosphor.

14. The light-emitting device according to any one of claims 1 to 8, comprising at least two types of red phosphors.

15. The light-emitting device according to claim 14, wherein the red phosphor comprises a CASN phosphor.

16. An illumination device comprising the light-emitting device according to any one of claims 1 to 15.

## INTERNATIONAL SEARCH REPORT

| | International application No. |
|---|---|
| | PCT/JP2018/006845 |

**A. CLASSIFICATION OF SUBJECT MATTER**

Int.Cl. F21V9/00(2018.01)i, C09K11/59(2006.01)i, C09K11/64(2006.01)i, C09K11/80(2006.01), F21V7/24(2018.01)i, F21V7/26(2018.01)i, F21V7/28(2018.01)i, F21V7/30(2018.01)i, H01L33/50(2010.01)i, F21Y115/00(2016.01)n

According to International Patent Classification (IPC) or to both national classification and IPC

**B. FIELDS SEARCHED**

Minimum documentation searched (classification system followed by classification symbols)

Int.Cl. F21V9/00, C09K11/59, C09K11/64, C09K11/80, F21V7/24, F21V7/26, F21V7/28, F21V7/30, H01L33/50, F21Y115/00

Documentation searched other than minimum documentation to the extent that such documents are included in the fields searched

| | |
|---|---|
| Published examined utility model applications of Japan | 1922-1996 |
| Published unexamined utility model applications of Japan | 1971-2018 |
| Registered utility model specifications of Japan | 1996-2018 |
| Published registered utility model applications of Japan | 1994-2018 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2015-144231 A (MITSUBISHI CHEMICAL CORPORATION) 06 August 2015, paragraphs [0009]-[0028], [0042], [0137], [0139],[0179]-[0191], [0198], [0224] & US 2016/0308097 A1, paragraphs [0017]-[0071], [0249], [0403], [0413], [0510]-[0531], [0541], [0598] & WO 2015/099115 A1 & EP 3091585 A2 & CN 105849920 A | 1-16 |

☒ Further documents are listed in the continuation of Box C.  ☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 13.04.2018 | 24.04.2018 |

| Name and mailing address of the ISA/ | Authorized officer |
|---|---|
| Japan Patent Office 3-4-3, Kasumigaseki, Chiyoda-ku, Tokyo 100-8915, Japan | Telephone No. |

Form PCT/ISA/210 (second sheet) (January 2015)

**INTERNATIONAL SEARCH REPORT**

International application No.

PCT/JP2018/006845

C (Continuation).   DOCUMENTS CONSIDERED TO BE RELEVANT

| Category* | Citation of document, with indication, where appropriate, of the relevant passages | Relevant to claim No. |
|---|---|---|
| Y | JP 2013-65555 A (MITSUBISHI CHEMICAL CORPORATION) 11 April 2013, paragraph [0097] & US 2014/0183578 A1, paragraph [0218] & WO 2013/031942 A1 & EP 2753150 A1 & CN 103299719 A | 1-16 |
| Y | JP 2003-535477 A (PATENT TREUHAND GES ELEKTR GLUEHLAMP MBH) 25 November 2003, paragraphs [0024]-[0028] & US 2003/0006469 A1, paragraphs [0032]-[0036] & WO 2001/093341 A1 & EP 1206802 A1 & DE 10026435 A1 & CA 2380444 A1 & TW 554030 B & CN 1381072 A & KR 10-2003-0007742 A | 13-16 |

Form PCT/ISA/210 (continuation of second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2013031942 A
- WO 2013031943 A
- WO 2015099115 A
- JP 2013058473 A
- JP H11258047 B
- JP 2016173949 A